**Europäisches Patentamt**

**European Patent Office**

**Office européen des brevets**

(19)

(11) Veröffentlichungsnummer: **0 121 189**
**B1**

(12) **EUROPÄISCHE PATENTSCHRIFT**

(45) Veröffentlichungstag der Patentschrift:
**24.06.87**

(51) Int. Cl.⁴: **H 01 J 23/34,** H 03 F 1/30

(21) Anmeldenummer: **84103197.4**

(22) Anmeldetag: **22.03.84**

(54) **Schaltungsanordnung zur temperaturabhängigen Nachführung der Steuerspannung in Wanderfeldröhren.**

(30) Priorität: **30.03.83 DE 3311674**

(43) Veröffentlichungstag der Anmeldung:
**10.10.84 Patentblatt 84/41**

(45) Bekanntmachung des Hinweises auf die Patenterteilung:
**24.06.87 Patentblatt 87/26**

(84) Benannte Vertragsstaaten:
**DE GB IT NL SE**

(56) Entgegenhaltungen:
**EP - A - 0 037 385**
**FR - A - 2 401 510**
**US - A - 3 254 265**
**US - A - 3 267 322**
**US - A - 3 316 485**

**IRE TRANSACTIONS ON COMMUNICATIONS**
**SYSTEMS, Band CS-10, Nr. 1, März 1962, Seiten 142-145,**
**New York, USA V.C. CHEWEY: "Beam-controlled linear**
**klystrom amplifiers for improved SSB efficiency"**

(73) Patentinhaber: **Siemens Aktiengesellschaft Berlin und**
**München, Wittelsbacherplatz 2, D-8000 München 2 (DE)**

(72) Erfinder: **Schmid, Eckart, Dipl.-Phys., Gotenweg 8,**
**D-8011 Poing (DE)**
Erfinder: **Wanninger, Ludwig, Dipl.-Ing.,**
**Pappelstrasse 10, D-8014 Neubiberg (DE)**

## Beschreibung

Die Erfindung betrifft eine Wanderfeldröhre mit einer Kathode zur Erzeugung eines Kathodenstroms, Schaltungsanordnung zur Konstanthaltung des Kathodenstroms.

Aus der FR-A 2 401 510 ist eine Wanderfeldröhre gemäss dem Oberbegriff des Patentanspruchs 1 bekannt. Der konstante Kathodenstrom wird durch eine Spannungsvariation an einer Steuerelektrode erreicht, und zwar durch Nachführung der Steuerspannung. Die Spannungsvariation wird so bestimmt, dass der Strom durch den Kathodenkreis gleich einer Bezugsgrösse ist.

In der US-A 3 267 322 ist beschrieben, wie die Temperatur einer Röhre konstant gehalten werden kann. Dazu wird die Temperatur der Hülle der Röhre mit einem temperaturabhängigen Netzwerk gemessen. Abhängig von der gemessenen Temperaturänderung wird der Elektronenstrahl von einer Elektronenlinse mehr oder weniger auf einem Kollektor fokussiert. Wenn der Elektronenstrahl nicht fokussiert ist, trifft er auf die Linsenelektrode und erwärmt diese so, dass die Temperaturänderung rückgängig gemacht wird. So wird die Temperatur und dadurch die Frequenz der Röhre stabilisiert.

Bei einer konstant anliegenden Steuerspannung ist der Kathodenstrom und damit die Verstärkung einer Wanderfeldröhre inkonstant bei Temperaturveränderungen. Der Grund hierfür liegt in der temperaturabhängigen Änderung des Steuerelektrode-Kathodenabstandes in der Röhre.

Der vorligenden Erfindung liegt die Aufgabe zugrunde, eine temperaturabhängige Nachführung der Steuerspannung zu erreichen, um einen relativ konstanten Kathodenstrom über die Erwärmung der Wanderfeldröhre zu erhalten.

Diese Aufgabe wird erfindungsgemäss dadurch gelöst, dass die Schaltungsanordnung mit der Wanderfeldröhre thermisch gekoppelt ist und ein temperaturabhängiges Netzwerk enthält, welches die Röhrentemperatur misst und über eine Steuerelektronik in einem Netzgerät durch eine von dieser Röhrentemperatur abhängige Spannung an der Steuerelektrode der Wanderfeldröhre den vorgewählten Kathodenstrom nahezu konstant hält.

Die Schaltungsanordnung ist dabei vorzugsweise in der Nähe der den Kathodenstrom bestimmenden Steuerelektroden angebracht und mit diesen thermisch gekoppelt.

Die erfindungsgemässe Wanderfeldröhre mit einer Schaltungsanordnung zur Konstanthaltung des Kathodenstroms hat den Vorteil, dass eine an geeigneter Stelle der Wanderfeldröhre angeordnete integrierte Schaltung als temperaturabhängiges Netzwerk die aktuelle Röhrentemperatur misst und über eine elektrisch leitende Verbindung vorzugsweise die Steuerspannung über einen Steuereingang im Netzgerät dergestalt nachführt, dass über einen weiten Temperaturbereich nahezu konstanter Kathodenstrom fliesst und die Ausgangsleistung dementsprechend konstant bleibt.

Die Erfindung wird anhand der Figuren der Zeichnung weiter erläutert. Es zeigen:

Fig. 1 den prinzipiellen Aufbau eines Wanderfeldröhrenverstärkers mit Temperaturkompensation und

Fig. 2 eine ausgeführte Schaltung.

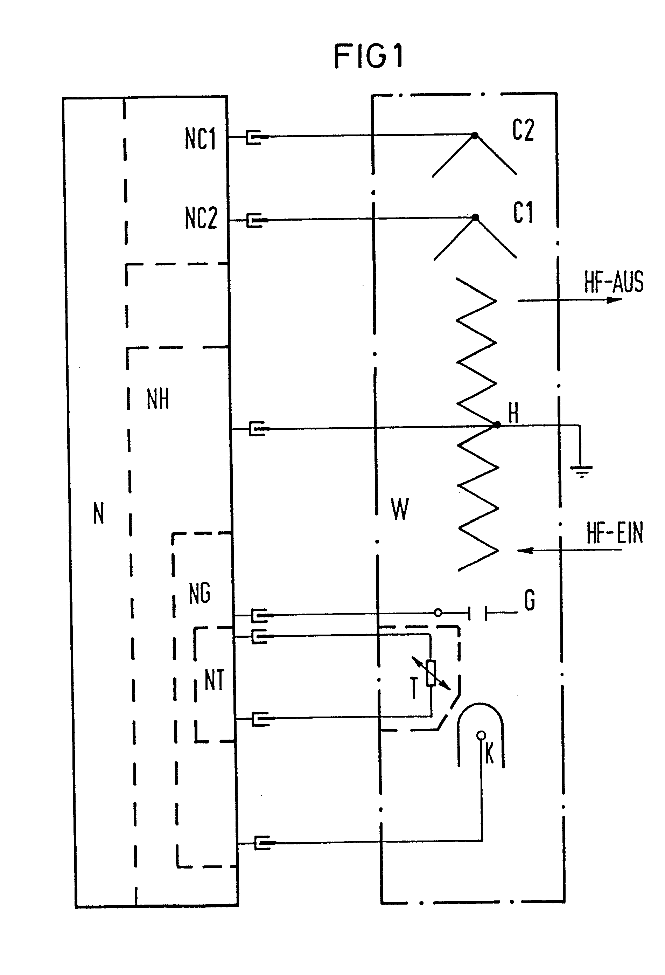

In Fig. 1 ist der prinzipielle Aufbau eines Wanderfeldröhrenverstärkers mit Temperaturkompensation dargestellt. Der Verstärker besteht aus dem Netzgerät N, der Wanderfeldröhre W und dem temperaturabhängigen Netzwerk T, welches die aktuelle Röhrentemperatur misst. Über eine Steuerelektronik im Netzgerät N lässt sich dabei der Kathodenstrom in der Wanderfeldröhre W durch eine von dieser Röhrentemperatur abhängige Spannung Steuerelektrode G, nahezu konstant halten. In diesem Ausführungsbeispiel besteht die Wanderfeldröhre W im wesentlichen aus der Kathode K, der Steuerelektrode G, der Wendel H sowie den Kollektoren C1 und C2. Das Netzgerät N setzt sich im wesentlichen aus den Kollektorspannungsquellen NC1 und NC2, der Wendelspannungsquelle NH, der Steuerspannungsquelle NG und der Temperaturnachführung NT zusammen. Die HF-Ein- und Ausgänge der Wanderfeldröhre W sind durch mit «Hf-EIN» und «HF-AUS» bezeichnete Pfeile angedeutet.

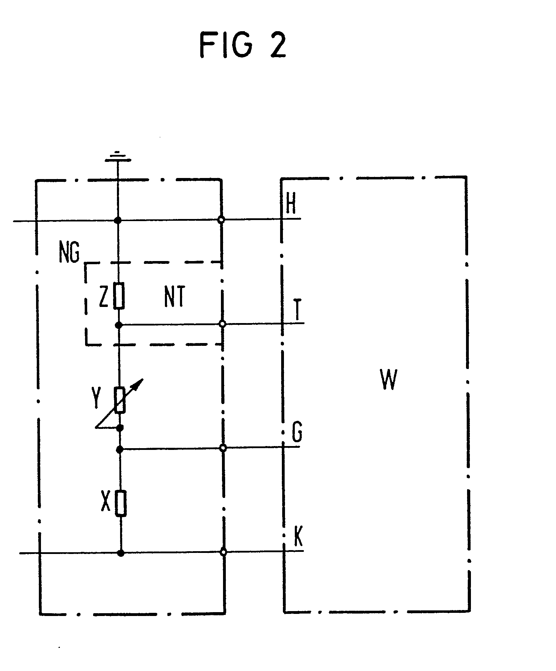

In Fig. 2 ist eine ausgeführte Schaltung dargestellt. Die Schaltung besteht im wesentlichen aus einem Hochspannungswiderstandteiler X, Y und Z, wobei mit dem Widerstand Y die Grundeinstellung des Kathodenstromes erfolgt. Dem Widerstand Z ist das temperaturabhängige Netzwerk T parallel geschaltet, derart, dass sich der Querstrom durch die Widerstände X, Y und Z mit der Änderung des Widerstandes im temperaturabhängigen Netzwerk T ändert und damit einhergehend eine auf die Kathode K bezogen Spannungsänderung am Widerstand X erfolgt. Die Spannung am Widerstand X beeinflusst über den Steuereingang der Steuerelektrode G der Wanderfeldröhre W den Kathodenstrom. Entsprechend Fig. 1 sind die Steuerspannungsquelle mit den Buchstaben NG und die in diesem Ausführungsbeispiel als Wendel ausgebildete Verzögerungsleitung mit dem Buchstaben H versehen.

## Patentansprüche

1. Wanderfeldröhre mit einer Kathode zur Erzeugung eines Kathodenstroms, einer der Kathode gegenüberliegenden Steuerelektrode und einer Schaltungsanordnung zur Konstanthaltung des Kathodenstroms, dadurch gekennzeichnet, dass die Schaltungsanordnung mit der Wanderfeldröhre (W) thermisch gekoppelt ist und ein temperaturabhängiges Netzwerk (T) enthält, welches die Röhrentemperatur misst und über eine Steuerelektronik (NT) in einem Netzgerät (N) durch eine von dieser Röhrentemperatur abhängige Spannung an der Steuerelektrode (G) der Wanderfeldröhre (W) den vorgewählten Kathodenstrom nahezu konstant hält.

2. Wanderfeldröhre nach Anspruch 1, dadurch gekennzeichnet, dass die Schaltungsanordnung in der Nähe der den Kathodenstrom bestimmenden Steuerelektrode (G) angebracht und thermisch mit dieser gekoppelt ist.

## Claims

1. A travelling wave tube comprising a cathode which produces a cathode current, a control electrode arranged opposite the cathode, and a circuit arrangement which maintains the cathode current constant, characterised in that the circuit arrangement is thermally-coupled to the travelling wave tube (W) and contains a temperature-dependent network (T) which measures the tube temperature and maintains the pre-selected cathode current virtually constant via an electronic control unit (NT) in a power supply unit (N) by means of a voltage dependent upon the tube temperature connected to the control electrode (G) of the travelling wave tube (W).

2. A travelling wave tube as claimed in claim 1, characterised in that the circuit arrangement is arranged in the vicinity of the control electrode (G), which determines the cathode current, and is thermally-coupled thereto.

## Revendications

1. Tube à ondes progressives comportant une cathode servant à produire un courant cathodique, une électrode de commande disposée en vis-à-vis de la cathode et un montage pour maintenir à une valeur constante le courant cathodique, caractérisé par le fait que le montage est accouplé thermiquement au tube à ondes progressives (W) et contient un réseau (A) dépendant de la température, qui mesure la température du tube et maintient approximativement constant le courant cathodique présélectionné, par l'intermédiaire d'un système électronique de commande (NT) dans un bloc d'alimentation (N) au moyen d'une tension, qui dépend de cette température du tube, appliquée à l'électrode de commande (G) du tube à ondes progressives (W).

2. Tube à ondes progressives suivant la revendication 1, caractérisé par le fait que le montage est disposé à proximité de l'électrode de commande (G) déterminant le courant cathodique et est accouplé thermiquement à cette électrode.

# FIG 1

# FIG 2